Europäisches Patentamt

European Patent Office

Office européen des brevets

(11) Publication number: **0 334 791**
A1

# EUROPEAN PATENT APPLICATION

(21) Application number: **89500039.6**

(22) Date of filing: **22.03.89**

(51) Int. Cl.4: **C 23 C 16/34**
H 01 L 21/318, C 04 B 41/87,
C 01 B 21/068

(30) Priority: **24.03.88 ES 8800898**

(43) Date of publication of application:
**27.09.89 Bulletin 89/39**

(84) Designated Contracting States:
**AT BE CH DE FR GB GR IT LI LU NL SE**

(71) Applicant: **UNION EXPLOSIVOS RIO TINTO, S.A.**
**Paseo de la Castellana 20**
**E-28046 Madrid (ES)**

(72) Inventor: **Gomez-Aleixandre Fernandez, Cristina**
**Avda. del Ferrol 29**
**E-28029 Madrid (ES)**

**Diaz Garrido, Domingo**
**Camarena 195**
**E-28047 Madrid (ES)**

**Serrano Martinez, Federico**
**Avda. de Betanzos 85**
**E-28034 Madrid (ES)**

**Albella Martin, Jose Maria**
**Nuria 91**
**E-28034 Madrid (ES)**

(74) Representative: **Garcia Cabrerizo, Francisco**
**OFICINA GARCIA CABRERIZO S.L. Vitruvio 23**
**E-28006 Madrid (ES)**

(54) **Process for the preparation of silicon nitride.**

(57) A process for the preparation of silicon nitride in the form of powder or a coating on components by the plasma assisted vapour phase chemical deposition technique (PECVD) at some 900-1100° C starting from gases containing nitrogen and silicon such as $N_2$, $NH_3$, $SiH_4$, $SiF_4$, $SiH_2Cl_2$, etc., and in the some cases $H_2$.

A product of suitable density which is free from impurities and can be used in electronic and structural applications is obtained at moderate temperatures in accordance with this process.

EP 0 334 791 A1

Description

## PROCESS FOR THE PREPARATION OF SILICON NITRIDE

PREAMBLE

Silicon nitride can be synthesised by three main types of process:

a) The direct nitriding of silicon, either in the form of powder or in the form of preformed and sintered pieces,

b) The reduction of silica with carbon and heat in accordance with the reaction $3SiO_2 + 6C + 2N_2 \rightarrow Si_3N_4 \, 6CO$.

c) A direct reaction between gases (such as $SiH_4$ and $NH_3$, $SiF_4$, $NH_3$, $N_2$ and $H_2$, $SiCl_4$ and $NH_3$, etc.) with the deposition of silicon nitride.

The latter type of process is known as chemical vapour phase deposition (CVD) and is very beneficial because different raw materials can be used without much additional modification.

Various processes operating above 1100°C which yield silicon nitride suitable for ceramic applications are in fact known. Among these mention should be made of those described in the work of Galasso et al. (J. Amer. Chem. Soc., 431 (1972)), where $SiF_4$ and $NH_3$ are reacted together at some 1100-1550°C, and in US patent 3,226,194 in which $SiF_4$ and $NH_3$ are also reacted together at a temperature between 1200 and 1900°C.

These high temperatures, which are necessary for thermal activation in order to provide an acceptable reaction rate, require the use of special equipment (high temperature furnaces or mechanical electrodes within the reactor, etc.). Because of this the high temperature zone must be confined within a small volume and very expensive materials must be used, so that the production of appreciable quantities of the product is very expensive.

The plasma assisted vapour phase chemical deposition technique (PECVD) is also known, and the fundamental characteristic of this is the use of a discharge, generally at radio frequencies, which encourages reaction at lower temperatures. Thus for example processes such as that described by S. Fujita et al. (J. Appl. Phys. 57 (2) (1985)), in which films are deposited on a substrate at a temperature around 400°C starting from $SiF_4$, $N_2$ and $H_2$ or $SiF_2$, $N_2$ and $N_2$ are known.

The problems raised by these processes are that the products obtained are of low density and include N-H, Si-H, N-F, etc., bonds, which appreciably restrict their possible applications, particularly structural applications.

This invention relates to a process for the production of silicon nitride by means of the PECVD technique in which a product of suitable density and freedom from impurities which can be used in electronic and structural applications is obtained, at moderate temperatures. This process does not require expensive materials for construction of the reactor and yields a high purity product free from bonds other than the N-Si bond which may arise from the starting materials.

DESCRIPTION

This invention relates to a process for the preparation of silicon nitride using the plasma assisted vapour phase chemical deposition technique (PECVD) starting from various gases which contain silicon and nitrogen and yielding a product in powder form or in the form of a coating on a substrate.

This process is carried out in reactors in which a part is heated by means of a furnace and provision is also made for a plasma induction system. The starting gases are fed in appropriate quantities to one end of the reactor and a pipe for discharge the gases after the reaction is provided at the other end.

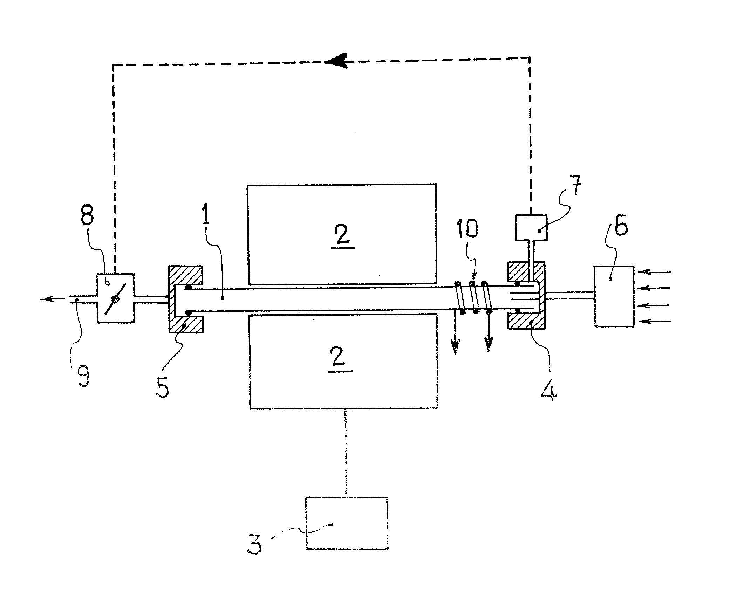

Figure 1, which will be described in detail below, shows an installation of this type although the invention may be embodied in other installations which include similar essential features while not of the same specific design.

Various combinations of starting gases may be used for the reaction. In general the silicon source is silane $SiH_4$ or a silicon halide such as $SiF_4$, $SiCl_4$, $SiH_2Cl_2$, etc.

For its part the nitrogen source may be $N_2$ itself and/or more frequently ammonia. In any event these two gases may be used simultaneously with the nitrogen being used as a vehicle for the reactants at the same time.

Finally it is advantageous to include hydrogen in the mixture of reacting gases, mainly in those cases in which silicon halides are used as a starting material.

The combinations of reactant gases $SiH_4$, $NH_3$ and $N_2$ on the one hand and $SiF_4$, $NH_3$, $N_2$ and $H_2$ on the other, having proportions around 1:15-20:100-200 and 1:7-12:3-6:15-35 respectively are particularly preferred for performance of this invention, although these proportions may be varied in relation to the specific design of the reactor, the substrate used, etc.

A very wide range of operating pressures may be used, irrespective of the gas flows. In fact deposits of the product may be obtained by working from a few millitorr up to some tens of torr. Nevertheless it is generally more advantageous to operate at pressures of between 1 and 10 torr for reasons involving both yield and equipment.

As may be seen from the prior art, the temperatures needed to achieve appreciable activation of the reaction are above 1100°C. In the process according to this invention however this activation is achieved at lower temperatures, between 900 and 1,000°C, by exciting the reacted molecules with a radio frequency plasma in such a way that satisfactory deposition rates of a very homogeneous and pure product are achieved, independently of the gases used as starting materials.

As far as the plasma induction system is concerned, both the frequency and the power used are as employed in the prior art, and may fall within a relatively wide range. Typical values may be 13.56 MHz for the frequency and 0.5-0.8 $W/cm^2$ for the power density.

The figure contains a sketch illustrating an installation in which the process according to this invention may be performed, although this process may also be performed in other installations of different specific design. The installation in the figure consists of a tubular quartz reactor (1) heated by a furnace (2) which has a temperature control (3) and is provided with two connections (4) and (5) for the entry and departure of the reaction gases. Flow may be controlled by means of automatic flowmeters (6) and the pressure may be controlled by an automatic controller (7) which acts on a variable aperture valve (8) located in the gas outlet line. The gases resulting from the reaction are removed via a discharge system (9). The plasma induction system consists of an induction coil (10) fed by a radio frequency source.

EXAMPLES

Example 1

The gases below were fed to a tubular quartz reactor 1 m long and of Ø 6.5 cm similar to that illustrated in Figure 1 with the flow rates also indicated:

$SiH_4$ 1.4 $cm^3/s$
$NH_3$ 25.0 $cm^3/s$
$N_2$ 169.0 $cm^3/s$.

The working pressure was held constant at 0.8 torr and at the temperature in the furnace area was 1,000°C.

Under these conditions and with a RF power of 100 W a film of silicon nitride was obtained on silicon substrates with a deposition rate of 0.1$\mu$m $h^{-1}$.

Analysis of this film by infrared spectroscopy demonstrated a single absorption band centred on 860 $cm^{-1}$, which corresponds to the Si-N bond. No further bands indicating the presence of N-H or Si-H bonds were apparent.

Example 2

A test with the induction coil positioned at the furnace outlet was performed using the same equipment, starting gases, flow, pressure and temperature as in example 1. A power of 300 W and an identical substrate (silicon) were used.

The deposition rate was then 1.0$\mu$m$h^{-1}$ and examination of the silicon nitride obtained by infrared spectroscopy again showed a single absorption band centred on 880 $cm^{-1}$ although rather wider, which can also be attributed to Si-N bonds.

Example 3

The following gases were fed to the same reactor as used in the foregoing examples with the flow rates indicated below:

$SiF_4$ 10 $cm^3/s$
$NH_3$ 100 $cm^3/s$
$N_2$ 45 $cm^3/s$
$H_2$ 200 $cm^3/s$.

The working pressure was held constant at 3.0 torr and the temperature in the furance area was 1,000°C.

Under these conditions and with a RF power of 400 W films of silicon nitride were obtained on silicon and graphite substrates with a deposition rate of 0.5$\mu$mh$^{-1}$ in both cases.

This rate is some 75% greater than that obtained under identical conditions without activation of the plasma by RF.

The films obtained were very homogeneous, and when examined by infrared spectroscopy showed a single absorption band centred on 850 $cm^{-1}$ which could be attributed to the Si-N bond. No bands attributable to Si-F, N-F, Si-H or N-H bonds were to be seen.

Example 4

The following gases were fed to the same reactor as used in the foregoing examples at the flow rates indicated below:

$SIF_4$ 30 $cm^3/s$
$NH_3$ 300 $cm^3/s$
$N_2$ 135 $cm^3/s$
$H_2$ 300 $cm^3/s$

The working pressure was held constant at 2.0 torr and the temperature in the furance was 1,000°C.

Under these conditions and with a RF power of 400 W films of silicon nitride were obtained on silicon and graphite substrates with a deposition rate of 0.75$\mu$mh$^{-1}$ in both cases.

The results of analyses of the films obtained were very similar to those in example 3.

**Claims**

1. A process for the preparation of silicon nitride in the form of powder or a film deposited on a substrate characterised in that it includes the following steps:

a) The reaction of at least one gas containing silicon and at least one gas containing nitrogen with or without molecular hydrogen at a temperature of between 900 and 1100°C and a pressure of up to 10 torr, the reaction between the said molecules being activated by plasma induction from a radio frequency discharge,

b) Deposition of the silicon nitride formed in the form of powder in the reaction chamber or in the form of a film on a substrate such as silicon, graphite, gallium arsenide or others, placed in the reaction chamber,

c) Removal of the gases produced by the reaction from the reaction chamber.

2. A process according to claim 1, characterised in that silicon halides and silanes such as silicon tetrafluoride, silicon difluoride, silicon tetrachloride, dichlorosilane and silane may be used as the gases containing silicon.

3. A process according to claim 1, characterised in that molecular nitrogen and ammonia may be used as the gases containing nitrogen.

4. A process according to claims 1 and 3, characterised in that the starting gases for the reaction are silane, ammonia, nitrogen and hydrogen.

5. A process according to claims 1 and 3, characterised in that the starting gases for the reaction are silicon tetrafluoride, ammonia, nitrogen and hydrogen.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | DE-A-1 621 234 (DEUTSCHE ITT INDUSTRIES LTD) * Page 4, lines 16-26; claims 1-4 * | 1-4 | C 23 C 16/34 H 01 L 21/318 C 04 B 41/87 C 01 B 21/068 |
| A | IEE PROCEEDINGS SECTION A á I, vol. 133, no. 4, part J, August 1986, pages 264-266, Stevenage, Herts, GB; N. NOURSHARGH et al.: "Plasma deposition of GeO2/SiO2 and Si3N4 waveguides for integrated optics" * Page 265, paragraph 3; page 266, paragraph 4 * | 1-3 | |
| A | US-A-4 704 300 (S. YAMAZAKI) * Abstract; column 2, lines 33-57; column 3, lines 15-30 * | 1-3,5 | |
| A | GB-A-1 199 811 (BRITISH TITAN PRODUCTS CO. LTD) * Page 3, lines 21-97; claims 1-13 * | 1-3 | |
| A | FR-A-2 591 412 (L'AIR LIQUIDE) * Page 6, lines 26-32; claim 1 * | 1-3 | TECHNICAL FIELDS SEARCHED (Int. Cl.4) |
| A | GB-A-2 170 143 (SUMITOMO ELECTRIC INDUSTRIES LTD) * Page 2, lines 39-45 * | 1 | C 23 C H 01 L C 04 B C 01 B |
| A | EP-A-0 015 694 (FUJITSU LTD) * Abstract; page 2, line 30 - page 3, line 15; page 4, line 21 - page 5, line 14 * | 1 | |
| A | US-A-4 089 992 (V.Y. DOO et al.) * Column 2, lines 46-60; column 3, lines 18-31 * | 1 | |

The present search report has been drawn up for all claims

| Place of search | Date of completion of the search | Examiner |
|---|---|---|
| THE HAGUE | 02-06-1989 | JOFFREAU P.O. |

EPO FORM 1503 03.82 (P0401)